(19) Europäisches Patentamt
European Patent Office
Office européen des brevets

(11) **EP 4 636 419 A1**

(12) **EUROPEAN PATENT APPLICATION**

(43) Date of publication:
**22.10.2025 Bulletin 2025/43**

(21) Application number: **25166612.9**

(22) Date of filing: **27.03.2025**

(51) International Patent Classification (IPC):
*G01R 31/367* (2019.01)   *G01R 31/3842* (2019.01)
*G01R 31/388* (2019.01)   *G01R 31/392* (2019.01)
*H01M 10/48* (2006.01)   *H02J 7/00* (2006.01)

(52) Cooperative Patent Classification (CPC):
**G01R 31/392; G01R 31/367; G01R 31/3842;
G01R 31/388; H01M 10/48; H02J 7/0048**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.04.2024 KR 20240050907**

(71) Applicant: SAMSUNG SDI CO., LTD.
**Yongin-si, Gyeonggi-do 17084 (KR)**

(72) Inventors:
• RYU, Ji-Hyun
  **17084 Yongin-si (KR)**
• KWON, Moonseok
  **17084 Yongin-si (KR)**
• KA, Bokhyun
  **17084 Yongin-si (KR)**
• HWANG, Taehyun
  **17084 Yongin-si (KR)**

(74) Representative: **Marks & Clerk LLP
15 Fetter Lane
London EC4A 1BW (GB)**

(54) **BATTERY CHARACTERISTIC DETECTION DEVICE AND METHOD**

(57)    The present disclosure relates to a battery characteristic detection device and method of a rechargeable battery. The battery characteristic detection device may include a control device configured to detect voltages and capacity variations of the rechargeable battery during a plurality of continuous charging/discharging cycles, and generate a charging/discharging curved line representing a relationship between the voltage and the capacity variation for each of the plurality of charging/discharging cycles. Each charging/discharging cycle may include a charging section and a discharging section. The control device may be further configured to select one of the charging section and the discharging section of a first charging/discharging cycle among the plurality of charging/discharging cycles as a reference section, determine a capacity of the rechargeable battery at a start or end time point of the reference section as a reference capacity, and obtain the capacity variation based on the reference capacity.

FIG. 1

## Description

### FIELD

The present disclosure relates to a battery characteristic detection device and method.

### BACKGROUND

A rechargeable battery differs from a primary battery in that it can be repeatedly charged and discharged, while the latter is incapable of being recharged. Low-capacity rechargeable batteries are used in portable small electronic devices such as smartphones, feature phones, laptop computers, digital cameras, and camcorders, and large-capacity rechargeable batteries are widely used as motor driving power and power storage devices such as hybrid vehicles and electric vehicles. The rechargeable battery includes an electrode assembly including a positive electrode and a negative electrode, a case accommodating the electrode assembly, and an electrode terminal connected to the electrode assembly.

The above information disclosed in this background section is only for enhancement of understanding of the background of the disclosure, and therefore it may contain information that does not form the prior art that is already known in this country to a person of ordinary skill in the art.

### SUMMARY

The present disclosure provides a battery characteristic detection device and method that may analyze a resistance characteristic of a rechargeable battery when it is operating.

However, the technical problem to be solved by the present disclosure is not limited to the above, and other objects not mentioned herein will be understood from the following description by those skilled in the art.

An aspect of the present disclosure relates to a battery characteristic detection device of a rechargeable battery. The battery characteristic detection device may include a control device configured to detect voltages and capacity variations of the rechargeable battery during a plurality of continuous charging/discharging cycles, and generate a charging/discharging curved line representing a relationship between the voltage and the capacity variation for each of the plurality of charging/discharging cycles. Each of the plurality of charging/discharging cycles may include a charging section and a discharging section. The control device may be further configured to select one of the charging section and the discharging section of a first charging/discharging cycle among the plurality of charging/discharging cycles as a reference section, determine a capacity of the rechargeable battery at a start or end time point of the reference section as a reference capacity, and obtain the capacity variation based on the reference capacity.

A charging/discharging rate in the first charging/discharging cycle may be 0.05 C or less. The control device may be further configured to determine a time point at which a state of charge (SOC) of the rechargeable battery is 0 % and a time point at which the SOC of the rechargeable battery is 100 % based on the start and end time points of the reference section, and may determine a capacity of the rechargeable battery at a time point at which the SOC of the rechargeable battery is 0 % or 100 % as the reference capacity.

The control device may be further configured to determine a capacity of the rechargeable battery at the start time point of the discharging section of the first charging/discharging cycle or the end time point of the charging section of the first charging/discharging cycle as the reference capacity, and calculate a discharged capacity as the capacity variation based on the reference capacity. The charging/discharging curved line of each of the plurality of charging/discharging cycles may include a charging curved line corresponding to the charging section and a discharging curved line corresponding to the discharging section. The discharging curved line may progress in a direction in which the voltage decreases and the capacity variation increases as discharging progresses, and the charging curved line may progress in a direction in which the voltage increases and the capacity variation decreases as charging progresses.

The control device may be further configured to determine a capacity at the start time point of the charging section of the first charging/discharging cycle or the end time point of the discharging section of the first charging/discharging cycle as the reference capacity, and calculate a charged capacity as the capacity variation based on the reference capacity. The charging/discharging curved line of each of the plurality of charging/discharging cycles may include a charging curved line corresponding to the charging section and a discharging curved line corresponding to the discharging section. The charging curved line may progress in a direction in which the voltage and the capacity variation increase as charging progresses, and the discharging curved line may progress in a direction in which the voltage and the capacity variation decrease as discharging progresses.

The charging/discharging curved line of each of the plurality of charging/discharging cycles may include a charging curved line corresponding to the charging section and a discharging curved line corresponding to the discharging section. The control device may be further configured to generate the charging/discharging curved line so that, for each charging/discharging cycle, the capacity variation at the end time point of the discharging curved line is the same as the capacity variation at the start time point of the charging curved line, or the capacity variation at the end time point of the charging curved line is the same as the capacity variation at the start time point of the discharging curved line.

The control device may be further configured to generate the charging/discharging curved line so that the capacity variation at the start time point of each charging/discharging cycle is the same as the capacity variation at the end time point of the previous charging/discharging cycle thereof.

The charging/discharging curved line of the first charging/discharging cycle may include a first charging curved line corresponding to the charging section and a first discharging curved line corresponding to the discharging section. The control device may be further configured to generate an open circuit voltage curved line using an average voltage value between the first charging curved line and the first discharging curved line.

The charging/discharging curved line of a second charging/discharging cycle among the plurality of charging/-discharging cycles may include a second charging curved line corresponding to the charging section of the second charging/discharging cycle and a second discharging curved line corresponding to the discharging section of the second charging/discharging cycle. The control device may be further configured to determine an overvoltage of a section in which the second charging/discharging cycle progresses, based on a voltage difference between the second charging curved line and the open circuit voltage curved line and a voltage difference between the second discharging curved line and the open circuit voltage curved line.

The control device may be further configured to determine a dynamic resistance of a section in which the second charging/discharging cycle progresses using the overvoltage and a charging/discharging current in the second charging/discharging cycle.

The first charging/discharging cycle and the second charging/discharging cycle may have different charging/-discharging rates.

Another aspect of the present disclosure relates to a battery characteristic detection method of a battery characteristic detection device. The battery characteristic detection method may include: measuring a voltage and a current of a rechargeable battery during a plurality of continuous charging/discharging cycles, obtaining a capacity variation of the rechargeable battery at each voltage measurement time point based on the measured current, and generating a charging/discharging curved line representing a relationship between the voltage and the capacity variation for each of the plurality of charging/discharging cycles. Each of the plurality of charging/discharging cycles may include a charging section and a discharging section. The obtaining of the capacity variation may include selecting one of the charging section and the discharging section of a first charging/discharging cycle among the plurality of charging/discharging cycles as a reference section, determining a capacity of the rechargeable battery at a start or end time point of the reference section as a reference capacity, and calculating the capacity variation based on the reference capacity.

A charging/discharging rate in the first charging/discharging cycle may be 0.05 C or less. The determining of the reference capacity may include determining a time point at which a state of charge (SOC) of the rechargeable battery is 0 % and a time point at which the SOC of the rechargeable battery is 100 % based on the start and end time points of the reference section, and determining a capacity of the rechargeable battery at a time point at which SOC of the rechargeable battery is 0 % or 100 % as the reference capacity.

The calculating may include calculating a discharged capacity as the capacity variation based on the reference capacity. The charging/discharging curved line of each of the plurality of charging/discharging cycles may include a charging curved line corresponding to the charging section and a discharging curved line corresponding to the discharging section. The discharging curved line may progress in a direction in which the voltage decreases and the capacity variation increases as discharging progresses, and the charging curved line may progress in a direction in which the voltage increases and the capacity variation decreases as charging progresses.

The calculating may include calculating a charged capacity as the capacity variation based on the reference capacity. The charging/discharging curved line of each of the plurality of charging/discharging cycles may include a charging curved line corresponding to the charging section and a discharging curved line corresponding to the discharging section. The charging curved line may progress in a direction in which the voltage and the capacity variation increase as charging progresses, and the discharging curved line may progress in a direction in which the voltage and the capacity variation decrease as discharging progresses.

The charging/discharging curved line of each of the plurality of charging/discharging cycles may include a charging curved line corresponding to the charging section and a discharging curved line corresponding to the discharging section. The generating of the charging/discharging curved line may include generating the charging/discharging curved line so that the capacity variation at the end time point of the discharging curved line is the same as the capacity variation at the start time point of the charging curved line for each charging/discharging cycle, or generating the charging/discharging curved line so that the capacity variation at the end time point of the charging curved line is the same as the capacity variation at the start time point of the discharging curved line for each charging/discharging cycle.

The generating of the charging/discharging curved line may include generating the charging/discharging curved line so that the capacity variation at the start time point of each charging/discharging cycle is the same as the capacity variation at the end time point of the previous charging/discharging cycle thereof.

The charging/discharging curved line of the first charging/discharging cycle may include a first charging curved line corresponding to the charging section and a first discharging curved line corresponding to the discharging section. The charging/discharging curved line of a second charging/discharging cycle among the plurality of charging/discharging cycles may include a second charging curved line corresponding to the charging section and a second discharging curved line corresponding to the discharging section. The battery characteristic detection method may further include generating an open circuit voltage curved line using an average voltage between the first charging curved line and the first discharging curved line, and determining an overvoltage of a section in which the second charging/discharging cycle progresses, from a voltage difference between the second charging curved line and the open circuit voltage curved line and a voltage difference between the second discharging curved line and the open circuit voltage curved line.

The battery characteristic detection method may further include determining a dynamic resistance of a section in which the second charging/discharging cycle progresses using the overvoltage and the current measured in the second charging/discharging cycle.

In the battery characteristic detection method, the first charging/discharging cycle and the second charging/-discharging cycle have different charging/discharging rates.

According to the present disclosure, it is possible to analyze the resistance characteristic of the rechargeable battery when it is operating.

However, effects obtainable through the present disclosure are not limited to the above, and other effects not mentioned herein will be clearly understood by those skilled in the art from the following disclosure.

At least some of the above and other features of the invention are set out in the claims.

## BRIEF DESCRIPTION OF THE DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 schematically illustrates a battery characteristic detection device of a rechargeable battery according to an embodiment.

FIG. 2A illustrates an example of a discharging reference charging/discharging curved line derived by a bend-over method in a battery characteristic detection device according to an embodiment.

FIG. 2B illustrates an example of a charging reference charging/discharging curved line derived by a bend-over method in a battery characteristic detection device according to an embodiment.

FIG. 3A illustrates an example of a charging/discharging curved line in which capacity variation coordinates are converted into depth of discharge (DOD) in a battery characteristic detection device according to an embodiment.

FIG. 3B illustrates an example of a charging/discharging curved line in which capacity variation coordinates are converted into state of charge (SOC) in a battery characteristic detection device according to an embodiment.

FIG. 4 illustrates an example of charging/discharging curved lines derived for two consecutive charging/discharging cycles using a bend-over method in a battery characteristic detection device according to an embodiment.

FIG. 5 illustrates another example of charging/discharging curved lines derived for a plurality of continuous charging/discharging curved lines in a battery characteristic detection device according to an embodiment.

FIG. 6 illustrates an example of a pseudo OCV curved line derived from a battery characteristic detection device according to an embodiment.

FIG. 7 is a drawing for explaining a method of deriving an overvoltage in a battery characteristic detection device according to an embodiment.

FIG. 8 illustrates an example of displaying a dynamic resistance curved line in a battery characteristic evaluation device according to an embodiment.

FIG. 9 schematically illustrates a battery characteristic detection method of a battery characteristic detection device according to an embodiment.

## DETAILED DESCRIPTION

Hereinafter, embodiments of the present disclosure will be described in detail with reference to the accompanying drawings. Prior to description, it should be understood that terms and words used in the specification and the appended claims should not be construed as having common and dictionary meanings, but should be interpreted as having meanings and concepts corresponding to technical ideas of the present disclosure in view of the principle that the inventor can properly define the concepts of the terms and words in order to describe his/her own disclosure as best as possible. Accordingly, since the embodiment described in the specification and the configurations shown in the drawings are merely the most preferable embodiment and configurations of the present disclosure, they do not represent all of the technical ideas of the present disclosure, and it should be understood that that various equivalents and modified examples, which may replace the embodiments, are possible when filing the present application. It will be further understood that the terms "comprise, include," "comprising," and/or "including," when used in this specification, specify the presence of the stated features, integers, steps, operations, elements, and/or components but do not preclude the presence or addition of one or more other features, integers, steps, operations, elements, components, and/or groups thereof. The use of "can/may" in describing an embodiment of the present disclosure may include "one or more embodiments of the present disclosure."

In addition, in order to help understanding of the present disclosure, the accompanying drawings are not drawn to scale, and the dimensions of some components may be exaggerated. In addition, the same reference numerals may be assigned to the same elements in different embodiments.

When it is explained that two objects are 'identical', this means that these objects are 'substantially identical'. Accordingly, the substantially identical objects may include deviations considered low in the art, for example, deviations within 5 %. In addition, when it is explained that certain parameters are uniform in a predetermined region, this may mean that the parameters are uniform in terms of an average in the corresponding region.

Although the terms "first", "second", and the like are used to describe various elements, these elements are not limited by these terms. These terms are used to distinguish one element from another, and unless stated to the contrary, a first element may be a second element.

Throughout the specification, unless stated otherwise, each element may be singular or plural.

When an element is "above (or under)" or "on (or below)" another element, the element can be on an upper surface (or a lower surface) of the other element, and intervening elements may be present between the element and the other element on (or below) the element.

In addition, when an element is referred to as being "connected", "coupled" or "linked" to another element, the element can be directly connected or coupled to the other element, but it should be understood that intervening elements may be present between each element, or each element may be "connected", "coupled" or "linked" to each other through another element. When one element is referred to as being coupled (e.g., electrically coupled or connected) to another element, the one element may be directly coupled to the other element or indirectly coupled to the other element via one or more intervening elements.

Throughout the specification, unless stated otherwise, "A and/or B" refers to A, B, or A and B. In other words, the term "and/or" includes all or various combinations of a plurality of items that are related and arranged. "C to D" refers to C or greater and D or smaller, unless stated otherwise.

Recently, the need for precise analysis of the characteristics of rechargeable batteries is increasing. Particularly, the resistance characteristics of rechargeable batteries are an indicator that greatly affects the performance of the rechargeable batteries, so precise analysis is required.

Conventional methods for analyzing the resistance characteristics of rechargeable batteries include direct current internal resistance (DC-IR), electrochemical impedance spectroscopy (EIS), and the like. The resistance measured using the conventional methods is close to the resistance measured when the rechargeable battery is stable after a certain rest period when the rechargeable battery is not driving. Therefore, it is difficult to analyze the resistance characteristics during driving of the rechargeable battery using the conventional analysis methods.

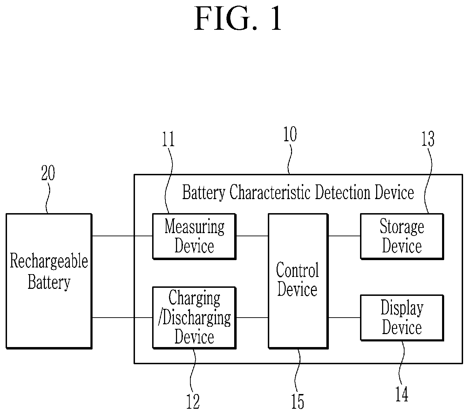

FIG. 1 schematically illustrates a battery characteristic detection device of a rechargeable battery according to an embodiment.

Referring to FIG. 1, a battery characteristic detection device 10 of a rechargeable battery according to an embodiment may include a measuring device 11, a charging/discharging device 12, a storage device 13, and a control device 15.

The measuring device 11 may measure a state value of a rechargeable battery 20, such as a voltage and a current.

The charging/discharging device 12 may charge or discharge the rechargeable battery 20 according to the control of the control device 15 described herein.

The storage device 13 may store various data, information, and the like processed by the battery characteristic detection device 10. The storage device 13 may store a program for operating the control device 15.

The control device 15 may control the overall operation of the battery characteristic detection device 10.

The control device 15 may control the charging/discharging device 12 to continuously perform a plurality of charging/discharging cycles at different charging/discharging rates (current rates, C-rates, or the like) for the rechargeable battery 20 whose battery characteristics are to be analyzed. In the present specification, continuous charging and discharging cycles may mean that when one charging and discharging cycle ends, the next charging and discharging cycle begins immediately thereafter. In addition, a charging section may be a section in which the rechargeable battery 20 is continuously charged from a full-discharged state to a full-charged state by the charging/discharging device 12, and a discharging section may be a section in which the rechargeable battery 20 is continuously discharged from a full-charged state to a full-discharged state by the charging/discharging device 12. One charging/discharging cycle may include one charging section and one discharging section. In addition, the charging section and the discharging section that constitute one charging/discharging cycle are consecutive time sections, and depending on the settings of the battery characteristic detection device 10, the charging section may be preceded by the discharging section or the discharging section may be preceded by the charging section.

At least one of the plurality of continuous charging/discharging cycles may proceed at an extremely low charging/discharging rate (for example, 0.05 C or less). For example, charging and discharging may be performed at a charging/discharging rate of 0.05 C in a first charging/discharging cycle among the plurality of continuous charging/-discharging cycles. In addition, at least one of the plurality of continuous charging/discharging cycles may proceed at a target charging/discharging rate (for example, 0.2 C, 0.33 C, or the like) to evaluate battery characteristics.

The control device 15 may control the measuring device 11 to periodically measure the voltage, current, and the like of the rechargeable battery 20 while the plurality of charging/discharging cycles are in progress. In addition, the control device 15 may periodically obtain a voltage value, a current value, and the like of the rechargeable battery 20 measured by the measuring device 11.

The control device 15 may also periodically detect the capacity variation of the rechargeable battery 20 based on the current measurement value of the rechargeable battery 20. The capacity variation may for example by a variation of actual capacity relative to a reference capacity. In order to determine a charging/discharging curved line described herein, the voltage value of the rechargeable battery 20 and the capacity value or capacity variation of the rechargeable battery 20 at the time point the corresponding voltage value is measured are required. The control device 15 may use the current measurement value to calculate the capacity variation in the time section between two consecutive voltage measurement time points (between the previous voltage measurement time point and the current voltage measurement time point) at each voltage measurement time point. Then, the control device 15 may calculate the capacity value or capacity variation of the rechargeable battery 20 at each voltage measurement time point by cumulatively calculating the capacity variation calculated in each time section.

The control device 15 may determine the initial capacity value of the rechargeable battery 20 at the start time point of the plurality of charging/discharging cycles as a specific value (for example, 5000 mAh or 0 mAh). Thereafter, the control device 15 may obtain the capacity value of the rechargeable battery 20 at each voltage measurement time point by continuously adding or subtracting the capacity variation calculated in each time section to or from the initial capacity value. In the charging section, the control device 15 may calculate the current capacity value of the rechargeable battery 20 by adding the capacity variation calculated in each time section to the previous capacity value. In the discharging section, the control device 15 may calculate the current capacity value of the rechargeable battery 20 by subtracting the capacity variation calculated in each time section from the previous capacity value.

The control device 15 may calculate the capacity variation in the time section between the previous voltage measurement time point and the current voltage measurement time point at each voltage measurement time point, and may calculate the capacity variation based on the initial state of the rechargeable battery 20 by cumulatively calculating the calculated capacity variation. That is, the control device 15 may calculate the capacity variation of the rechargeable battery 20 based on the start time point of the plurality of charging/discharging cycles for each voltage measurement time by cumulatively calculating the capacity variation calculated at each voltage measurement time point from the start of the plurality of charging/discharging cycles according to the charging/discharging direction. In this case, when the capacity variation is calculated based on the discharged capacity, the control device 15 may calculate the capacity variation at each voltage measurement time point by subtracting the capacity variation calculated in the charging section from the accumulated calculated capacity variation and adding the capacity variation calculated in the discharging section to the accumulated calculated capacity variation. When the capacity variation is calculated based on the charged capacity, the control device 15 may calculate the capacity variation at each voltage measurement time point by adding the capacity variation calculated in the charging section to the accumulated calculated capacity variation and subtracting the capacity variation calculated in the discharging section from the accumulated calculated capacity variation.

When the capacity value or capacity variation of the rechargeable battery 20 at each voltage measurement time point is determined, the control device 15 may map the voltage value of the rechargeable battery 20 at each voltage measurement time point and the corresponding capacity value/capacity variation to each other and store them in the storage device 13. The control device 15 may also store the current value of the rechargeable battery 20 detected at each voltage measurement time point in the storage device 13.

The control device 15 may generate a charging/discharging curved line based on the voltage value and capacity variation of the rechargeable battery 20 detected at each voltage measurement time point during the plurality of charging/discharging cycles. The charging/discharging curved line may represent the voltage variation according to the capacity variation of the rechargeable battery 20 in the form of a curved line.

Hereinafter, an operation in which the control device 15 generates a charging/discharging curved line detected in each charging/discharging cycle will be described in detail with reference to the drawings.

The control device 15 may generate a charging/discharging curved line using a bend-over method.

In the bend-over method, in the process of deriving the charging/discharging curved line, a reference capacity that serves as a standard for aligning the charging/discharging curved line in the coordinate space may be determined. For example, in the bend-over method, the capacity when the state of charge (SOC) is 0 % or the capacity when the SOC is 100 % may be set as the standard capacity. In addition, for example, in the bend-over method, the capacity when depth of discharge (DOD) is 0 % or the capacity when the DOD is 100 % may be set as the reference capacity.

In the bend-over method, it is assumed that the rechargeable battery 20 reacts reversibly in a charging/discharging cycle in which the rechargeable battery 20 is charged and discharged at an extremely low rate of 0.05 C or less (hereinafter referred to as 'extremely low rate charging/discharging cycle'). Under this assumption, the control device 15 may determine a point at which the state of the rechargeable battery 20 is SOC 0 % and SOC 100 % (or DOD 0 % and DOD 100 %) based on the discharging section in the extremely low rate charging/discharging cycle or the charging section in the extremely low rate charging/discharging cycle. For example, in the extremely low rate charging/discharging cycle, the control device 15 may determine the start time point of the discharging section to be in a state in which the rechargeable battery 20 is SOC 100 %, and may determine the end time point of the discharging section to be in a state in which the rechargeable battery 20 is SOC 0 %. In addition, for example, in the extremely low rate charging/discharging cycle, the control device 15 may determine the start time point of the charging section to be in a state in which the rechargeable battery 20 is SOC 0 %, and may determine the end time point of the charging section to be in a state in which the rechargeable battery 20 is SOC 100 %.

In the bend-over method, when the reference capacity is determined, the capacity variation at each voltage measurement time point may be calculated based on the reference capacity. Here, calculating the capacity variation at each voltage measurement time point based on the reference capacity means calculating how much the capacity of the rechargeable battery 20 at each voltage measurement time point has changed relative to the reference capacity. In addition, on the charging/discharging curved line, the point when the capacity of the rechargeable battery 20 is the reference capacity means that the capacity variation coordinate is positioned at 0. In addition, this means that as the capacity variation calculated based on the reference capacity increases, the charging/discharging curved line progresses in the direction in which the coordinate value of the capacity variation increases and that as the capacity variation calculated based on the reference capacity decreases, the charging/discharging curved line progresses in the direction in which the capacity variation coordinate value decreases.

The control device 15 may convert the capacity value or capacity variation of the rechargeable battery 20 calculated based on the current measurement value at each voltage measurement time point into a capacity variation based on the reference capacity. For example, the control device 15 may calculate the discharged capacity based on the reference capacity as a capacity variation. In this case, if the rechargeable battery 20 is discharged by more than the reference capacity, the capacity variation of the rechargeable battery 20 may be calculated as a positive value, and if the rechargeable battery 20 is charged by more than the reference capacity, the capacity variation of the rechargeable battery 20 may be calculated as a negative value. In addition, for example, the control device 15 may calculate the charged capacity as the capacity variation based on the reference capacity. In this case, if the rechargeable battery 20 is charged by more than the reference capacity, the capacity variation of the rechargeable battery 20 may be calculated as a positive value, and if the rechargeable battery 20 is discharged by more than the reference capacity, the capacity variation of the rechargeable battery 20 may be calculated as a negative value.

Hereinafter, Table 1 to Table 4 show examples of calculating the capacity variation based on the reference capacity in the bend-over method.

(Table 1)

| | Detection time point | 1st charging/discharging cycle (0.05 C) | | 2nd charging/discharging cycle (0.33 C) | |
|---|---|---|---|---|---|
| | | Charging | Discharging | Charging | Discharging |
| Detection capacity [mAh] | Start time point | 0 | 5000 | 12 | 4735 |
| | End time point | 5000 | 12 | 4735 | 34 |
| Capacity variation (Before conversion) [mAh] | Start time point | 0 | 5000 | 12 | 4735 |
| | End time point | 5000 | 12 | 4735 | 34 |
| Capacity variation (After conversion) [mAh] | Start time point | 5000 | 0 | 4988 | 265 |
| | End time point | 0 | 4988 | 265 | 4966 |

(Table 2)

| | Detection time point | 1st charging/discharging cycle (0.05 C) | | 2nd charging/discharging cycle (0.33 C) | |
| --- | --- | --- | --- | --- | --- |
| | | Charging | Discharging | Charging | Discharging |
| Detection capacity [mAh] | Start time point | 0 | 5000 | 12 | 4735 |
| | End time point | 5000 | 12 | 4735 | 34 |
| Capacity variation (Before conversion) [mAh] | Start time point | 0 | 5000 | 12 | 4735 |
| | End time point | 5000 | 12 | 4735 | 34 |
| Capacity variation (After conversion) [mAh] | Start time point | -12 | 4988 | 0 | 4723 |
| | End time point | 4988 | 0 | 4723 | 22 |

(Table 3)

| | Detection time point | 1st charging/discharging cycle (0.05 C) | | 2nd charging/discharging cycle (0.33 C) | |
| --- | --- | --- | --- | --- | --- |
| | | Charging | Discharging | Charging | Discharging |
| Detection capacity [mAh] | Start time point | 0 | 5000 | 12 | 4735 |
| | End time point | 5000 | 12 | 4735 | 34 |
| Capacity variation (Before conversion) [mAh] | Start time point | 0 | 5000 | 12 | 4735 |
| | End time point | 5000 | 12 | 4735 | 34 |
| Capacity variation (After conversion) [mAh] | Start time point | 0 | 5000 | 12 | 4735 |
| | End time point | 5000 | 12 | 4735 | 34 |

(Table 4)

| | Detection time point | 1st charging/discharging cycle | | 2nd charging/discharging cycle | |
| --- | --- | --- | --- | --- | --- |
| | | Charging | Discharging | Charging | Discharging |
| Detection capacity [mAh] | Start time point | 0 | 5000 | 12 | 4735 |
| | End time point | 5000 | 12 | 4735 | 34 |
| Capacity variation (Before conversion) [mAh] | Start time point | 0 | 5000 | 12 | 4735 |
| | End time point | 5000 | 12 | 4735 | 34 |
| Capacity variation (After conversion) [mAh] | Start time point | 5000 | 0 | 4988 | 265 |
| | End time point | 0 | 4988 | 265 | 4966 |

Table 1 to Table 4 all show a case in which two charging/discharging cycles are consecutive and the first charging/discharging cycle is an extremely low rate charging/discharging cycle.

In Table 1 to Table 4, the detection capacity of the rechargeable battery 20 is derived by cumulatively calculating the capacity variation calculated based on the current measurement value assuming that the capacity value at the start time point of the first charging/discharging cycle is 0 mAh. The capacity values of the rechargeable battery 20 detected at the start time point and the end time point of the charging section of the first charging/discharging cycle are 0 mAh and 5000 mAh, respectively. The capacity charged in the rechargeable battery 20 during this first charging section is 5000 mAh. In addition, the capacity values of the rechargeable battery 20 detected at the start time point and the end time point of the discharging section of the first charging/discharging cycle are 5000 mAh and 12 mAh, respectively. The capacity discharged from the rechargeable battery 20 during this first discharging section is 4988 mAh. In addition, the capacity values of the rechargeable battery 20 detected at the start time point and the end time point of the charging section of the second charging/discharging cycle are 12 mAh and 4735 mAh, respectively. The capacity charged in the rechargeable battery 20 during this second charging section is 4723 mAh. In addition, the capacity values of the rechargeable battery 20 detected at the start time point and the end time point of the discharging section of the second charging/discharging cycle are 4735 mAh and 34 mAh, respectively. The capacity discharged from the rechargeable battery 20 during this second discharging section is 4701 mAh.

In Table 1 to Table 4, the capacity variation (before conversion) of the rechargeable battery 20 is derived by cumulatively calculating the capacity variation calculated based on the current measurement value from the start time point of the first charging/discharging cycle according to the charging/discharging direction. The capacity variations (before conversion) calculated at the start and end time points of the charging section of the first charging/discharging cycle are 0 mAh and 5000 mAh, respectively. In addition, the capacity variations (before conversion) calculated at the start and end time points of the discharging section of the first charging/discharging cycle are 5000 mAh and 12 mAh, respectively. In addition, the capacity variations (before conversion) calculated at the start and end time points of the charging section of the second charging/discharging cycle are 12 mAh and 4735 mAh, respectively. In addition, the capacity variations (before conversion) calculated at the start and end time points of the discharging section of the second charging/discharging cycle are 4735 mAh and 34 mAh, respectively.

Table 1 shows a case in which the discharge section of the first charging/discharging cycle is selected as a reference section, the capacity at the start time point of the discharge section selected as the reference section is selected as the reference capacity, and the discharged capacity based on the selected reference capacity is calculated as the capacity variation (after conversion). In Table 1, the capacity variations (after conversion) calculated at the start and end time points of the charging section of the first charging/discharging cycle are 5,000 mAh and 0 mAh, respectively. In addition, the capacity variations (after conversion) calculated at the start and end time points of the discharging section of the first charging/discharging cycle are 0 mAh and 4988 mAh, respectively. In addition, the capacity variations (after conversion) calculated at the start and end time points of the charging section of the second charging/discharging cycle are 4988 mAh and 265 mAh, respectively. In addition, the capacity variations (after conversion) calculated at the start and end time points of the discharging section of the second charging/discharging cycle are 265 mAh and 4966 mAh, respectively.

Table 2 shows a case in which the discharge section of the first charging/discharging cycle is selected as a reference section, the capacity at the end time point of the discharge section selected as the reference section is selected as the reference capacity, and the charged capacity based on the selected reference capacity is calculated as the capacity variation (after conversion). In Table 2, the capacity variations (after conversion) calculated at the start and end time points of the charging section of the first charging/discharging cycle are -12 mAh and 4988 mAh, respectively. In addition, the capacity variations (after conversion) calculated at the start and end time points of the discharging section of the first charging/discharging cycle are 4988 mAh and 0 mAh, respectively. In addition, the capacity variations (after conversion) calculated at the start and end time points of the charging section of the second charging/discharging cycle are 0 mAh and 4723 mAh, respectively. In addition, the capacity variations (after conversion) calculated at the start and end time points of the discharging section of the second charging/discharging cycle are 4723 mAh and 22 mAh, respectively.

Table 3 shows a case in which the charging section of the first charging/discharging cycle is selected as a reference section, the capacity at the start time point of the charging section selected as the reference section is selected as the reference capacity, and the charged capacity based on the selected reference capacity is calculated as the capacity variation (after conversion). In Table 3, the capacity variations (after conversion) calculated at the start and end time points of the charging section of the first charging/discharging cycle are 0 mAh and 5,000 mAh, respectively. In addition, the capacity variations (after conversion) calculated at the start and end time points of the discharging section of the first charging/discharging cycle are 5,000 mAh and 12 mAh, respectively. In addition, the capacity variations (after conversion) calculated at the start and end time points of the charging section of the second charging/discharging cycle are 12 mAh and 4735 mAh, respectively. In addition, the capacity variations (after conversion) calculated at the start and end time points of the discharging section of the second charging/discharging cycle are 4735 mAh and 34 mAh, respectively.

Table 4 shows a case in which the charging section of the first charging/discharging cycle is selected as a reference section, the capacity at the end time point of the charging section selected as the reference section is selected as the reference capacity, and the charged capacity based on the selected reference capacity is calculated as the capacity variation (after conversion). In Table 4, the capacity variations (after conversion) calculated at the start and end time points of the charging section of the first charging/discharging cycle are 5,000 mAh and 0 mAh, respectively. In addition, the capacity variations (after conversion) calculated at the start and end time points of the discharging section of the first charging/discharging cycle are 0 mAh and 4988 mAh, respectively. In addition, the capacity variations (after conversion) calculated at the start and end time points of the charging section of the second charging/discharging cycle are 4988 mAh and 265 mAh, respectively. In addition, the capacity variations (after conversion) calculated at the start and end time points of the discharging section of the second charging/discharging cycle are 265 mAh and 4966 mAh, respectively.

In the bend-over method, as described above, when the capacity variation of the rechargeable battery 20 at each voltage measurement time point is converted into a value based on the reference capacity, a charging/discharging curved line may be derived by aligning the voltage values based on the converted capacity variation.

In the following description, the capacity discharged from the reference capacity (for example, the capacity of the rechargeable battery 20 when SOC is 100 % or DOD is 0 %) is determined as a capacity variation of the rechargeable battery 20, and the charging/discharging curved line derived based on the determined capacity variation is referred to as a "discharging reference charging/discharging curved line". In addition, the capacity charged from the reference capacity (for example, the capacity of the rechargeable battery 20 when SOC is 0 % or DOD is 100 %) is determined as a capacity variation of the rechargeable battery 20, and the charging/discharging curved line derived based on the determined capacity variation is referred to as a "charging reference charging/discharging curved line". In the discharging reference charging/discharging curved line, the capacity variation may be proportional to the DOD of the rechargeable battery 20 and inversely proportional to the SOC of the rechargeable battery 20. In the charging reference charging/discharging curved line, the capacity variation may be inversely proportional to the DOD of the rechargeable battery 20 and proportional to the SOC of the rechargeable battery 20.

For example, in a case in which a point where a state of the rechargeable battery 20 is SOC 0 % and SOC 100 % (or DOD 0 % and DOD 100 %) is determined based on a discharging section in an extremely low rate charging/discharging cycle, the control device 15 may calculate a capacity variation (discharged capacity) based on the capacity (capacity when SOC is 100 %) of the rechargeable battery 20 at the start time point of the discharging of the extremely low rate charging/discharging cycle (see Table 1), and derive a discharging reference charging/discharging curved line based on this. In addition, the control device 15 may calculate a capacity variation (charged capacity) based on the capacity (capacity when SOC is 0 %) of the rechargeable battery 20 at the end time point of the discharging of the extremely low rate charging/discharging cycle (see Table 2), and derive a charging reference charging/discharging curved line based on this.

In addition, for example, in a case in which a point where a state of the rechargeable battery 20 is SOC 0 % and SOC 100 % (or DOD 0 % and DOD 100 %) is determined based on a charging section in an extremely low rate charging/discharging cycle, the control device 15 may calculate a capacity variation (charged capacity) based on the capacity (capacity when SOC is 0 %) of the rechargeable battery 20 at the start time point of the charging of the extremely low rate charging/discharging cycle (see Table 3), and derive a charging reference charging/discharging curved line based on this. In addition, the control device 15 may calculate a capacity variation (discharged capacity) based on the capacity (capacity when SOC is 100 %) of the rechargeable battery 20 at the end time point of the charging of the extremely low rate charging/discharging cycle (see Table 4), and derive a discharging reference charging/discharging curved line based on this.

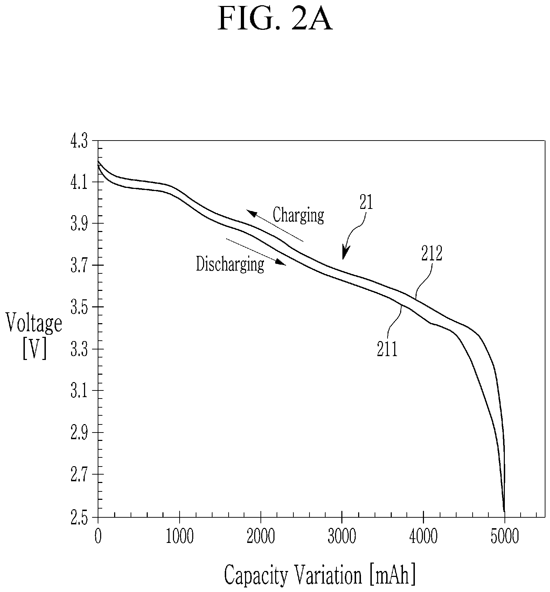

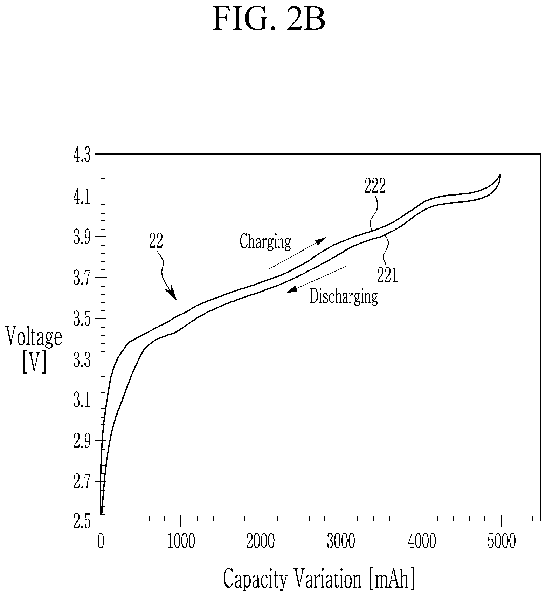

FIG. 2A and FIG. 2B illustrate examples of charging/discharging curved lines derived by a bend-over method in a battery characteristic detection device according to an embodiment. FIG. 2A illustrates a discharging reference charging/discharging curved line derived from an extremely low rate charging/discharging cycle. In addition, FIG. 2B illustrates a charging reference charging/discharging curved line derived from an extremely low rate charging/discharging cycle.

Referring to FIG. 2A and FIG. 2B, charging/discharging curved lines 21 and 22 are illustrated on a coordinate plane with voltage [V] and capacity variation [mAh] as two coordinate axes. In each of the charging/discharging curved lines 21 and 22, the x-axis coordinate may represent a capacity variation (discharged capacity or charged capacity) of the rechargeable battery 20, and the y-axis coordinate may represent a voltage value of the rechargeable battery 20. Each of the charging/discharging curved lines 21 and 22 may include discharging curved lines 211 and 221 and charging curved lines 212 and 222.

In the discharging reference charging/discharging curved line 21 of FIG. 2A, a capacity variation may be determined based on the capacity of the rechargeable battery 20 when the SOC is 100 %.

Therefore, in the discharging curved line 211, the x coordinate representing the capacity variation may gradually increase as the discharging progresses, and the y coordinate representing the voltage may gradually decrease as the discharging progresses. That is, the discharging curved line 211 may be generated to progress to the right (that is, in a direction in which the capacity variation increases) as the discharging progresses. In addition, in the charging curved line 212, the x coordinate representing the capacity variation may gradually decrease as the charging progresses, and the y coordinate representing the voltage may gradually increase as the charging progresses. That is, the charging curved line 212 may be generated to progress to the left (that is, in a direction in which the capacity variation decreases) as the charging progresses. In this way, the discharging curved line 211 and the charging curved line 212 may proceed in opposite directions.

In the charging reference charging/discharging curved line 22 of FIG. 2B, a capacity variation may be determined based on the capacity of the rechargeable battery 20 when the SOC is 0 %.

Therefore, in the discharging curved line 221, the x coordinate representing the capacity variation and the y coordinate representing the voltage may gradually decrease as the discharging progresses. That is, the discharging curved line 221 may be generated to progress to the left (that is, in a direction in which the capacity variation decreases) as the discharging progresses. In addition, in the charging curved line 222, the x coordinate representing the capacity variation and the y coordinate representing the voltage may gradually increase as the charging progresses. That is, the charging curved line 222 may be generated to progress to the right (that is, in a direction in which the capacity variation increases) as the charging progresses. In this way, the discharging curved line 221 and the charging curved line 222 may proceed in opposite directions.

In one charging/discharging cycle, the charging and discharging sections may be continuous with each other. Accordingly, as shown in Table 1 to Table 4, the capacity at the end time point of the preceding section among the charging section and the discharging section may be the capacity at the start time point of the next section. For example, when discharging is preceded, the capacity of the rechargeable battery 20 at the end time point of the discharging section may be regarded as the capacity of the rechargeable battery 20 at the start time point of the charging section. In addition, for example, when charging is preceded, the capacity of the rechargeable battery 20 at the end time point of the charging section may be regarded as the capacity of the rechargeable battery 20 at the start time point of the discharging section. Accordingly, the discharging curved lines 211 and 221 and the charging curved lines 212 and 222 of each charging/-discharging cycle may be configured so that on the coordinate axis (x-axis) representing the capacity variation, the point where one curved line ends coincides with the point where the other curved line starts. Referring to FIG. 2A as an example, when discharging is preceded, on the coordinate axis representing the capacity variation, the point at which the discharging curved line 211 ends may coincide with the point at which the charging curved line 212 starts. In addition, referring to FIG. 2B as an example, when charging is preceded, on the coordinate axis representing the capacity variation, the point at which the charging curved line 222 ends may coincide with the point at which the discharging curved line 221 starts.

The capacity variation of the charging/discharging curved line is a value calculated by calculating an increased or decreased capacity based on one reference capacity (for example, capacity at SOC 0 %, or capacity at SOC 100 %). Accordingly, the control device 15 may convert the coordinates of the capacity variations of the charging/discharging curved lines 21 and 22 into the capacity coordinates of the rechargeable battery 20. In addition, the control device 15 may determine voltage values mapped to the same capacity variation coordinates in the charging/discharging curved lines 21 and 22 as voltage values detected in the same capacity of the rechargeable battery 20.

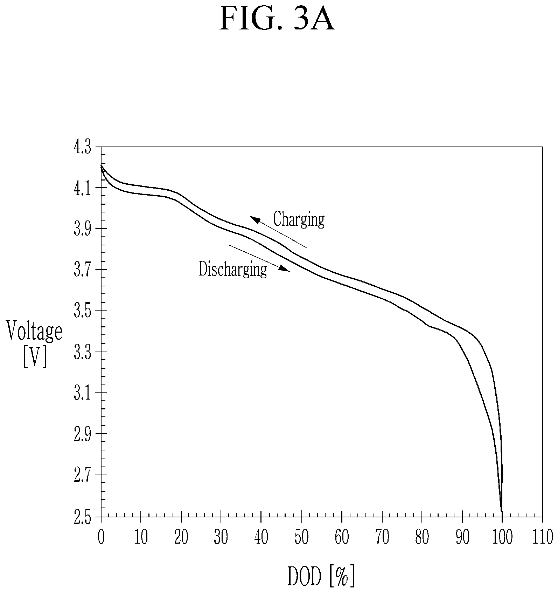

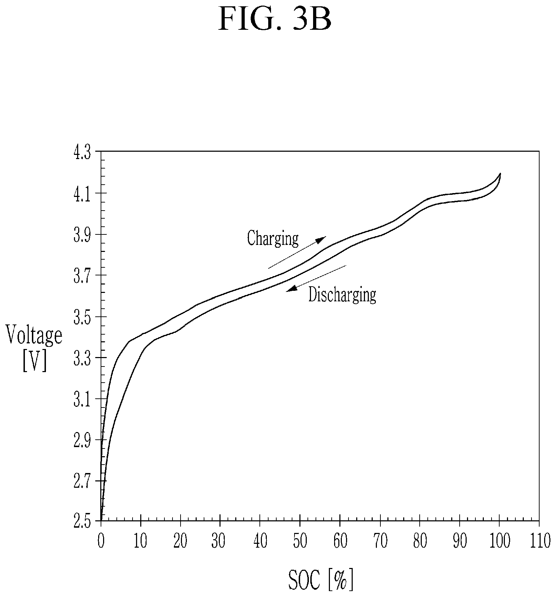

As described herein, the capacity variation in the charging/discharging curved line has a proportional/inversely proportional relationship with the DOD or SOC of the rechargeable battery 20. Accordingly, the control device 15 may convert the capacity variation coordinates into DOD or SOC coordinates. FIG. 3A illustrates an example of a charging/-discharging curved line when the capacity variation coordinates are converted into DOD, and FIG. 3B illustrates an example of a charging/discharging curved line when the capacity variation coordinates are converted into SOC. Referring to FIG. 3A and FIG. 3B, the control device 15 may easily identify voltage values detected in the same DOD or SOC of the rechargeable battery 20 in the charging/discharging curved lines 21 and 22 by converting the capacity variation coordinates into DOD or SOC.

As described herein, the control device 15 controls the rechargeable battery 20 to continuously perform a plurality of charging/discharging cycles. Accordingly, as shown in Table 1 to Table 4, the capacity of the rechargeable battery 20 at the end time point of each charging/discharging cycle may be regarded as the capacity of the rechargeable battery 20 at the start time point of the next charging/discharging cycle. Therefore, when the charging/discharging curved line is configured in the above-described bend-over method, the charging/discharging curved line may be configured so that the point at which the charging/discharging curved line of the previous charging/discharging cycle ends and the point at which the next charging/discharging cycle starts coincide with each other on the coordinate axis representing the capacity variation. For example, when the charging/discharging curved line of the previous charging/discharging cycle ends at the point where the capacity variation coordinate is 265 mAh, the charging/discharging curved line of the next charging/-discharging cycle may start at the point where the capacity variation coordinate is 265 mAh.

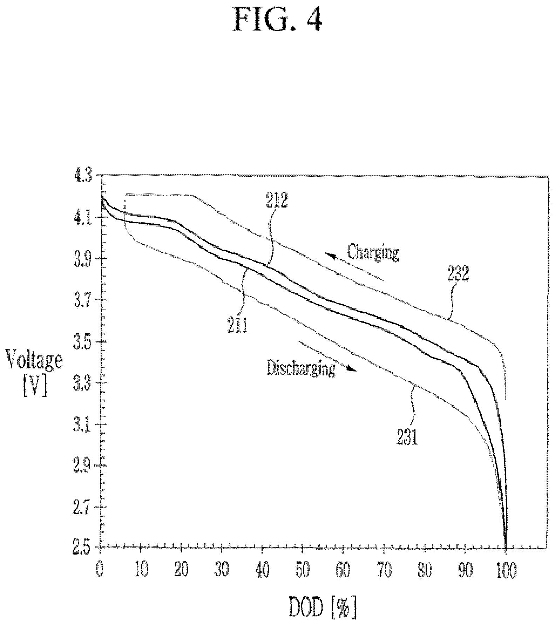

FIG. 4 illustrates an example of charging/discharging curved lines derived for two consecutive charging/discharging cycles using a bend-over method in a battery characteristic detection device according to an embodiment. The charging/discharging curved lines of FIG. 4 are charging/discharging curved lines in the case in which charging and discharging are sequentially performed at a charging/discharging rate of 0.05 C in the first charging/discharging cycle, and then charging and discharging are sequentially performed at a charging/discharging rate of 0.33 C in the second charging/discharging cycle. In the charging/discharging curved lines of FIG. 4, the capacity variation coordinate is converted into DOD and illustrated. The charging/discharging curved lines of FIG. 4 are discharging reference charging/discharging curved lines derived by corresponding the start time point and the end time point of the discharging section of the first charging/discharging cycle to points of DOD 0 % and DOD 100 %, respectively.

Referring to FIG. 4, the charging curved line 212 of the first charging/discharging cycle may start near the point where the DOD is 100 %. The charging curved line 212 of the first charging/discharging cycle may progress in the direction in which the DOD coordinate decreases as charging progresses, and may end at the point where DOD is 0 %. The discharging curved line 211 of the first charging/discharging cycle may start at the DOD coordinate where the charging curved line 212 of the first charging/discharging cycle ends, that is, the point where DOD is 0 %. The discharging curved line 211 of the first charging/discharging cycle may progress in the direction in which the DOD coordinate increases as discharging progresses, and may end at the point where DOD is 100 %. The charging curved line 232 of the second charging/discharging cycle that is progressed thereafter may start at the DOD coordinate where the discharging curved line 221 of the first charging/discharging cycle ends, that is, the point where DOD is 100 %. The charging curved line 232 of the second charging/discharging cycle may progress in the direction in which the DOD coordinate decreases as charging progresses. The discharging curved line 231 of the second charging/discharging cycle may start at the DOD coordinate in which the charging curved line 232 of the second charging/discharging cycle ends, and may progress in the direction in which the DOD coordinate increases as the discharging progresses.

For example, in the case in which the charging and discharging capacities in the first charging/discharging cycle are 5,000 mAh and 4,988 mA, respectively, and the charging and discharging capacities in the second charging/discharging cycle are 4,723 mAh and 4,701 mAh, respectively, the charging curved line 212 of the first charging/discharging cycle may start at the point where the DOD coordinate is about 100.2 % (=(5000/4988)×100) and may end at the point where the DOD coordinate is 0 %. In addition, the discharging curved line 211 of the first charging/discharging cycle may start at the point where the charging curved line 212 of the first charging/discharging cycle ends, that is, at the point where the DOD coordinate is 0 %, and may end at the point where the DOD coordinate is 100 %. In addition, the charging curved line 232 of the second charging/discharging cycle may start at the point where the discharging curved line 211 of the first charging/discharging cycle ends, that is, at the point where the DOD coordinate is 100 %, and may end at the point where the DOD coordinate is about 5.3 % (=(((4988-4723)/4988)×100). In addition, the discharging curved line 231 of the second charging/discharging cycle may start at the point where the charging curved line 232 of the second charging/discharging cycle ends, that is, at the point where the DOD coordinate is about 5.3 %, and may end at the point where the DOD coordinate is about 99.6 % (=((4988-4723+4701)/4988)×100).

As described above, when the charging/discharging curved lines are determined by the bend-over method, charging/discharging curved lines of different charging/discharging rates may be simultaneously shown on one coordinate plane. In addition, it may be easier to compare voltage values at the same capacity in the charging/discharging curved lines of different charging/discharging rates. In addition, it is possible to intuitively understand the irreversibility that occurs as the charging and discharging of the rechargeable battery 20 is repeated.

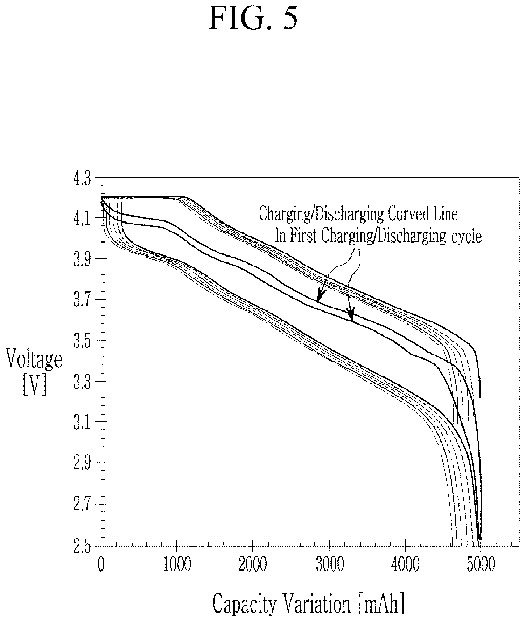

FIG. 5 illustrates another example of charging/discharging curved lines derived for a plurality of continuous charging/discharging curved lines in a battery characteristic detection device according to an embodiment.

Referring to FIG. 5, it may be seen that the charging start and end capacities and the discharging start and end capacities of the charging/discharging curved lines at other charging/discharging cycles are changed, compared to charging/discharging curved lines at the first charging/discharging cycle.

Referring back to FIG. 1, when the charging/discharging curved line of each charging/discharging cycle is obtained, the control device 15 may store it in the storage device 13. The control device 15 may store charging rate information of each charging/discharging cycle and coordinate data (voltage coordinates and capacity variation coordinates) corresponding to each point of each charging/discharging curved line in the storage device 13 in the form of a lookup table. In addition, the control device 15 may additionally store at least one of the capacity coordinate, the SOC coordinate, and the DOD coordinate corresponding to each point in the coordinate data of the charging/discharging curved line.

When the charging/discharging curved line of each charging/discharging cycle is determined, the control device 15 may determine the overvoltage and dynamic resistance of the rechargeable battery 20 using the same. The dynamic resistance corresponds to a difference value between the resistance of the rechargeable battery 20 in a stable state (that is, an open circuit state) and the resistance of the rechargeable battery 20 while dynamically reacting (while charging/-discharging). In other words, the dynamic resistance is a numerical expression of a resistance value that dynamically changes due to the charging/discharging of the rechargeable battery 20. This dynamic resistance may be used as a key indicator in analyzing the performance of rechargeable batteries.

Hereinafter, an operation in which the control device 15 determines the overvoltage and dynamic resistance of the rechargeable battery 20 will be described in detail with reference to necessary drawings.

In order to determine the overvoltage and dynamic resistance, the control device 15 may determine a pseudo open circuit voltage (OCV) curved line of the rechargeable battery 20 from a charging/discharging curved line of an extremely low rate charging/discharging cycle in which the rechargeable battery 20 is considered to reversibly react.

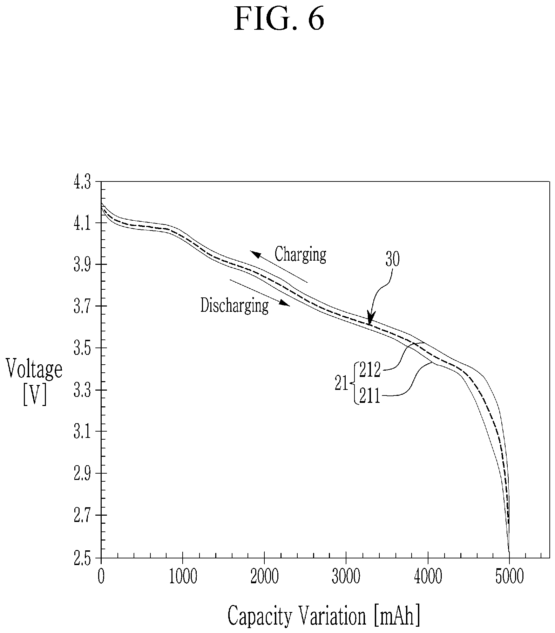

FIG. 6 illustrates an example of a pseudo OCV curved line derived from a battery characteristic detection device according to an embodiment.

Referring to FIG. 6, the control device 15 may calculate a voltage average value of the charging/discharging curved line 21 on the voltage coordinate axis, and may connect the calculated voltage average value to derive the pseudo OCV curved line 30. That is, the control device 15 may calculate the average value of the voltage value in the discharging curved line 211 and the voltage value in the charging curved line 212 for each capacity variation coordinate, and may connect the calculated average values along the capacity variation coordinate axis to derive the pseudo OCV curved line 30.

As described above, the coordinate of the capacity variation may be converted into the capacity coordinate, SOC coordinate, or DOD coordinate of the rechargeable battery 20. Accordingly, the control device 15 may obtain the pseudo OCV curved line of the entire capacity section, the entire SOC section, or the entire DOD section of the rechargeable battery 20 using the pseudo OCV curved line 30 obtained in the above-described manner.

When the control device 15 obtains the pseudo OCV curved line, the control device 15 may store it in the storage device 13. The control device 15 may store coordinate data (voltage coordinate and capacity variation coordinate) corresponding to each point of the pseudo-OCV curved line in the storage device 13 in the form of a lookup table. In addition, the control device 15 may additionally store at least one of the capacity coordinate, SOC coordinate, and/or DOD coordinate corresponding to each point in the coordinate data for each point of the pseudo OCV curved line.

The control device 15 may determine the overvoltage at each charging/discharging cycle using the pseudo OCV curved line and the charging/discharging curved line in each charging/discharging cycle. The control device 15 may calculate the voltage difference between each charging/discharging curved line and the pseudo OCV curved line, and may derive the overvoltage of the rechargeable battery 20 in the corresponding charging/discharging cycle based on this.

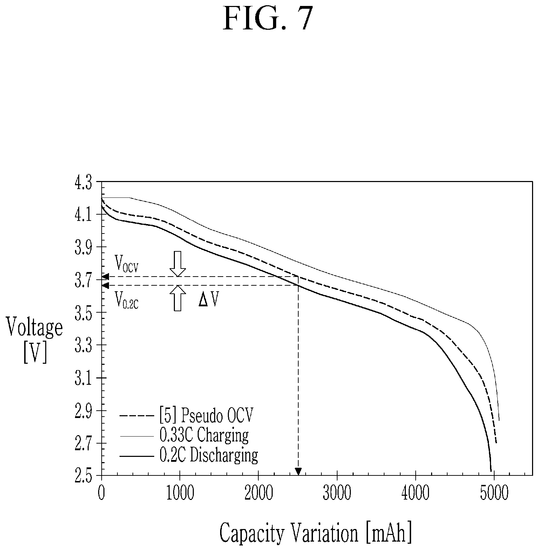

FIG. 7 is a drawing for explaining a method of deriving an overvoltage in a battery characteristic detection device according to an embodiment. The curved lines of FIG. 7 illustrate the pseudo OCV curved line, the charging curved line when charged at a charging/discharging rate of 0.33 C, and the discharging curved line when discharged at a charging/discharging rate of 0.2 C, respectively.

When the charging/discharging curved line is derived by the bend-over method described above, the control device 15 may simultaneously display the pseudo OCV curved line and the charging/discharging curved line on one coordinate plane. In addition, as shown in FIG. 7, the control device 15 may easily extract the pseudo OCV voltage value ($V_{OCV}$) corresponding to the same capacity variation and the voltage value of the charging/discharging curved line (for example, the voltage value ($V_{0.2C}$) of the 0.2C charge curved line). In addition, the control device 15 may calculate the extracted pseudo OCV voltage value ($V_{OCV}$) and the voltage value ($V_{0.2C}$) of the charging/discharging curved line, and may use the calculated voltage difference (V) to obtain an overvoltage at the corresponding capacity variation.

In this way, the control device 15 may obtain the overvoltage when the rechargeable battery 20 is charged and discharged at each charging/discharging rate. The control device 15 may store the detected overvoltage in the storage device 13. The control device 15 may store a lookup table corresponding to an overvoltage value corresponding to each point of the charging/discharging curved line in the storage device 13. Accordingly, an overvoltage value corresponding to coordinate data corresponding to each point of the charging/discharging curved line may be stored in the storage device 13.

When an overvoltage value at each point of the charging/discharging curved line is detected, the control device 15 may use it to calculate a dynamic resistance at each point of the charging/discharging curved line. Equation 1 below represents a method of calculating a dynamic resistance value ($R_D$) from an overvoltage value.

[Equation 1]

$$R_D = |\, V_{ocv} - V_{C\text{-}rate}\, |\, /\, I_{C\text{-}rate} = \Delta V\, /\, I_{C\text{-}rate}$$

In Equation 1 above, $V_{OCV}$ and $V_{C\text{-}rate}$ represent a pseudo-OCV voltage value and a voltage value of the charging/discharging curved line, respectively, and both $V_{OCV}$ and $V_{C\text{-}rate}$ are extracted from the same capacity variation coordinate. In addition, $I_{C\text{-}rate}$ may represent a charging/discharging current value used to derive a corresponding charging/discharging curved line.

The control device 15 may detect dynamic resistance for the entire section of the charging/discharging curved line using Equation 1 above.

The control device 15 may store the detected dynamic resistance in the storage device 13. The control device 15 may store a lookup table corresponding to a dynamic resistance value corresponding to each point of the charging/-discharging curved line in the storage device 13. Accordingly, a dynamic resistance value corresponding to coordinate data corresponding to each point of the charging/discharging curved line may be stored in the storage device 13.

The control device 15 may display the charging/discharging curved line, the pseudo-OCV curved line, the overvoltage curved line, and the dynamic resistance curved line obtained by the above-described method on the screen of the display device 14. The overvoltage curved line is a curved line generated by connecting overvoltage values detected for respective points of the charging/discharging curved line to each other, and may intuitively represent an overvoltage behavior for the entire capacity section of the rechargeable battery 20. In addition, the dynamic resistance curved line is a curved line generated by connecting dynamic resistance values detected for respective points of the charging/discharging curved line to each other, and may intuitively represent a dynamic resistance behavior for the entire capacity section of the rechargeable battery 20.

The control device 15 may convert the capacity variation coordinate into the capacity coordinate, SOC coordinate, or DOD coordinate. Accordingly, when the control device 15 displays a graph including the charging/discharging curved line, the pseudo-OCV curved line, the overvoltage curved line, or the dynamic resistance curved line on the screen of the display device 14, the control device 15 may convert and display the capacity variation coordinates into capacity coordinates, SOC coordinates, DOD coordinates, or the like.

The control device 15 may include at least one processor. The processor may refer to a data processing device having a physically structured circuit to perform a function expressed by code or instructions included in a program, such as a microprocessor, a central processing unit (CPU), a processor core, a multiprocessor, an application-specific integrated circuit (ASIC), a field programmable gate array (FPGA), and the like.

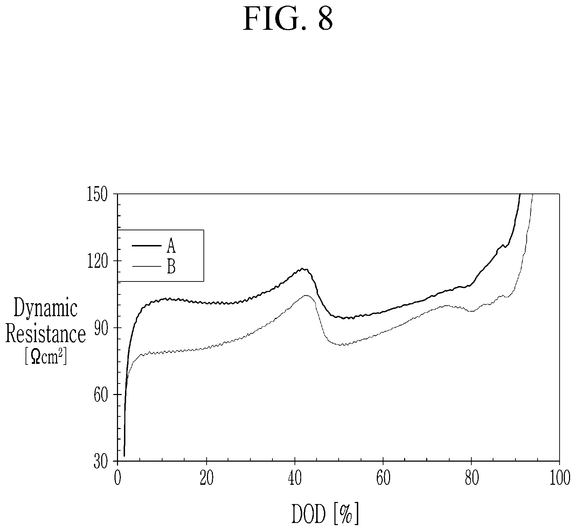

FIG. 8 illustrates an example of displaying a dynamic resistance curved line in a battery characteristic evaluation device according to an embodiment. FIG. 8 illustrates dynamic resistance values detected for two different experimental groups A and B as a graph based on DOD.

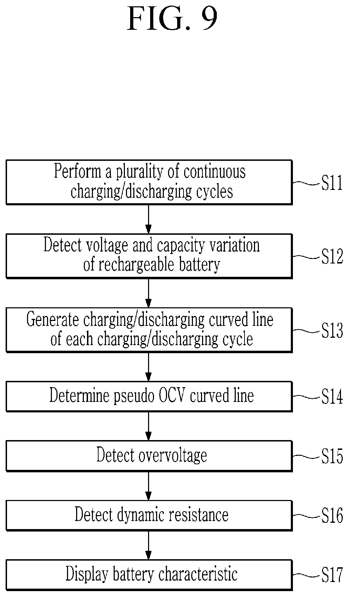

Hereinafter, a battery characteristic detection method of the battery characteristic detection device 10 according to the embodiment will be described in detail with reference to FIG. 9.

FIG. 9 schematically illustrates a battery characteristic detection method of the battery characteristic detection device 10 according to the embodiment. The method of FIG. 9 may be performed by the control device 15 of the battery characteristic detection device 10 described with reference to FIG. 1.

The battery characteristic detection device 10 may continuously perform a plurality of charging/discharging cycles at different charging/discharging rates (Current rate, C-rate) for the rechargeable battery 20 whose battery characteristics are to be analyzed (S11).

In step S11, the battery characteristic detection device 10 may control the charging/discharging device 12 to continuously perform the plurality of charging/discharging cycles for the rechargeable battery 20. The battery characteristic detection device 10 may control the charging/discharging device 12 so that charging and discharging proceed at an extremely low rate (for example, 0.05 C or less) in at least one of the plurality of charging/discharging cycles. The battery characteristic detection device 10 may control the charging/discharging device 12 so that at least one of the plurality of charging/discharging cycles proceeds to a target charging/discharging rate (for example, 0.2 C, 0.33 C, or the like) to evaluate battery characteristics.

The battery characteristic detection device 10 may detect the voltages and the capacity variations of the rechargeable battery 20 during the plurality of charging/discharging cycles (S12).

In step S12, the battery characteristic detection device 10 may periodically detect the voltage value of the rechargeable battery 20 through the measuring device 11. That is, the battery characteristic detection device 10 may detect the voltage value of the rechargeable battery 20 through the measuring device 11 at a plurality of voltage measurement time points while the plurality of charging/discharging cycles are in progress.

In step S12, the battery characteristic detection device 10 may periodically detect the current of the rechargeable battery 20. In addition, the battery characteristic detection device 10 may determine the capacity variation of the rechargeable battery 20 at each voltage measurement time point based on the detected current value. The battery characteristic detection device 10 may determine the reference capacity to determine the capacity variation at each voltage measurement time point. The charging section or discharging section of the extremely low rate charging/discharging cycle may be selected as a reference section for determining the reference capacity. For example, the battery characteristic detection device 10 may determine the start and end time points of the discharging section of the extremely low rate charging/discharging cycle as the state when SOC is 0 % or 100 %, respectively, and may determine the capacity of the rechargeable battery 20 at the start or end time points of the discharging section as the reference capacity.

The battery characteristic detection device 10 may generate a charging/discharging curved line of each charging/discharging cycle based on the voltage and capacity variation of the rechargeable battery 20 detected through step S12 (S13).

In step S13, the battery characteristic detection device 10 may generate a charging/discharging curved line using the bend-over method described above. The battery characteristic detection device 10 may generate a charging/discharging curved line using the voltage and capacity variation of the rechargeable battery 20 as two coordinate axes using the bend-over method. The generated charging/discharging curved line may be converted into a charging/discharging curved line using voltage and capacity, voltage and SOC, or voltage and DOD as two coordinate axes.

The battery characteristic detection device 10 may determine a pseudo OCV curved line by using a charging/-discharging curved line of the extremely low rate charging/discharging cycle among the charging/discharging curved lines derived in step S13 (S14).

In step S14, the battery characteristic detection device 10 may calculate an average of voltage values (an average of a voltage value at the discharging curved line and a voltage value at the charging curved line) at the charging/discharging curved line of the extremely low rate charging/discharging cycle for each capacity variation coordinate, and may connect the calculated average values to derive the pseudo OCV curved line.

The battery characteristic detection device 10 may detect the overvoltage of the rechargeable battery 20 in each charging/discharging cycle using the pseudo OCV curved line determined through step S14 (S15).

In step S15, the battery characteristic detection device 10 may determine the overvoltage in each charging/-discharging cycle using the pseudo OCV curved line and the charging/discharging curved line in each charging/discharging cycle. The battery characteristic detection device 10 may calculate the voltage difference between each charging/-discharging curved line and the pseudo OCV curved line, and may derive the overvoltage of the rechargeable battery 20 in the corresponding charging/discharging cycle based on this.

The battery characteristic detection device 10 may detect the dynamic resistance of the rechargeable battery 20 in each charging/discharging cycle using the overvoltage detected through step S15 (S16). In step S16, the battery characteristic detection device 10 may calculate the dynamic resistance of the rechargeable battery 20 by dividing the overvoltage detected for each point of the charging/discharging curved line by the charging/discharging current through step S15.

The battery characteristic detection device 10 may display the battery characteristics of the rechargeable battery 20 on the screen of the display device 14 using at least one of the charging/discharging curved line, the pseudo OCV curved line, the overvoltage curved line, and the dynamic resistance curved line obtained in the above-described manner (S17).

While this technology has been described in connection with what is presently considered to be practical embodiments, it is to be understood that the technology is not limited to the disclosed embodiments, but, on the contrary, is intended to cover various modifications and equivalent arrangements included within the scope of the appended claims.

Embodiments are set out in the following numbered clauses:

1. A battery characteristic detection device of a rechargeable battery, comprising:

a control device configured to:

detect voltages and capacity variations of the rechargeable battery during a plurality of continuous charging/-discharging cycles; and

generate a charging/discharging curved line representing a relationship between the voltage and the capacity variation for each of the plurality of charging/discharging cycles,

wherein each of the plurality of charging/discharging cycles includes a charging section and a discharging section, and

wherein the control device is further configured to:

select one of the charging section and the discharging section of a first charging/discharging cycle among the plurality of charging/discharging cycles as a reference section;

determine a capacity of the rechargeable battery at a start or end time point of the reference section as a reference capacity, and obtain the capacity variation based on the reference capacity.

2. The battery characteristic detection device of clause 1, wherein:

a charging/discharging rate in the first charging/discharging cycle is 0.05 C or less; and

the control device is further configured to:

determine a time point at which a state of charge (SOC) of the rechargeable battery is 0 % and a time point at which the SOC of the rechargeable battery is 100 % based on the start and end time points of the reference section; and

determine a capacity of the rechargeable battery at a time point at which the SOC of the rechargeable battery is 0 % or 100 % as the reference capacity.

3. The battery characteristic detection device of clause 1 or clause 2, wherein:
the control device is further configured to:

determine a capacity of the rechargeable battery at the start time point of the discharging section of the first charging/discharging cycle or the end time point of the charging section of the first charging/discharging cycle as the reference capacity; and

calculate a discharged capacity as the capacity variation based on the reference capacity; and wherein:

the charging/discharging curved line of each of the plurality of charging/discharging cycles includes a charging curved line corresponding to the charging section and a discharging curved line corresponding to the discharging section;

the discharging curved line progresses in a direction in which the voltage decreases and the capacity variation increases as discharging progresses; and

the charging curved line progresses in a direction in which the voltage increases and the capacity variation decreases as charging progresses.

4. The battery characteristic detection device of any preceding clause, wherein:
the control device is further configured to:

determine a capacity at the start time point of the charging section of the first charging/discharging cycle or the end time point of the discharging section of the first charging/discharging cycle as the reference capacity; and

calculate a charged capacity as the capacity variation based on the reference capacity; and wherein:

the charging/discharging curved line of each of the plurality of charging/discharging cycles includes a charging curved line corresponding to the charging section and a discharging curved line corresponding to the discharging section;

the charging curved line progresses in a direction in which the voltage and the capacity variation increase as charging progresses; and

the discharging curved line progresses in a direction in which the voltage and the capacity variation decrease as discharging progresses.

5. The battery characteristic detection device of any preceding clause, wherein:

the charging/discharging curved line of each of the plurality of charging/discharging cycles includes a charging curved line corresponding to the charging section and a discharging curved line corresponding to the discharging section; and

the control device is further configured to generate the charging/discharging curved line so that, for each charging/discharging cycle, the capacity variation at the end time point of the discharging curved line is the same as the capacity variation at the start time point of the charging curved line, or the capacity variation at the end time point of the charging curved line is the same as the capacity variation at the start time point of the discharging curved line.

6. The battery characteristic detection device of any preceding clause, wherein the control device is further configured to generate the charging/discharging curved line so that the capacity variation at the start time point of each charging/discharging cycle is the same as the capacity variation at the end time point of the previous charging/-discharging cycle thereof.

7. The battery characteristic detection device of any preceding clause, wherein:

the charging/discharging curved line of the first charging/discharging cycle includes a first charging curved line corresponding to the charging section and a first discharging curved line corresponding to the discharging section; and

the control device is further configured to generate an open circuit voltage curved line using an average voltage value between the first charging curved line and the first discharging curved line.

8. The battery characteristic detection device of clause 7, wherein:

the charging/discharging curved line of a second charging/discharging cycle among the plurality of charging/-discharging cycles includes a second charging curved line corresponding to the charging section of the second charging/discharging cycle and a second discharging curved line corresponding to the discharging section of the second charging/discharging cycle; and

the control device is configured to determine an overvoltage in the second charging/discharging cycle, based on a voltage difference between the second charging curved line and the open circuit voltage curved line and a voltage difference between the second discharging curved line and the open circuit voltage curved line.

9. The battery characteristic detection device of clause 8, wherein the control device is further configured to determine a dynamic resistance in the second charging/discharging cycle using the overvoltage and a charging/discharging current in the second charging/discharging cycle.

10. The battery characteristic detection device of clause 8 or clause 9, wherein the first charging/discharging cycle and the second charging/discharging cycle have different charging/discharging rates.

11. A battery characteristic detection method of a battery characteristic detection device, comprising:

measuring a voltage and a current of a rechargeable battery during a plurality of continuous charging/discharging cycles;

obtaining a capacity variation of the rechargeable battery at each voltage measurement time point based on the measured current; and

generating a charging/discharging curved line representing a relationship between the voltage and the capacity variation for each of the plurality of charging/discharging cycles,

wherein each of the plurality of charging/discharging cycles includes a charging section and a discharging section, and

wherein the obtaining of the capacity variation includes:

selecting one of the charging section or the discharging section of a first charging/discharging cycle among the plurality of charging/discharging cycles as a reference section;

determining a capacity of the rechargeable battery at a start or end time point of the reference section as a reference capacity; and calculating the capacity variation based on the reference capacity.

12. The battery characteristic detection method of clause 11, wherein:

a charging/discharging rate in the first charging/discharging cycle is 0.05 C or less; and

the determining of the reference capacity includes:

determining a time point at which a state of charge (SOC) of the rechargeable battery is 0 % and a time point at which the SOC of the rechargeable battery is 100 % based on the start and end time points of the reference section, and

determining a capacity of the rechargeable battery at a time point at which the SOC of the rechargeable battery is 0 % or 100 % as the reference capacity.

13. The battery characteristic detection method of clause 11 or clause 12, wherein:

the calculating includes calculating a discharged capacity as the capacity variation based on the reference capacity;

the charging/discharging curved line of each of the plurality of charging/discharging cycles includes a charging curved line corresponding to the charging section and a discharging curved line corresponding to the discharging section;

the discharging curved line progresses in a direction in which the voltage decreases and the capacity variation increases as discharging progresses; and

the charging curved line progresses in a direction in which the voltage increases and the capacity variation decreases as charging progresses.

14. The battery characteristic detection method of any of clauses 11 to 13, wherein:

the calculating includes calculating a charged capacity as the capacity variation based on the reference capacity;

the charging/discharging curved line of each of the plurality of charging/discharging cycles includes a charging curved line corresponding to the charging section and a discharging curved line corresponding to the discharging section;

the charging curved line progresses in a direction in which the voltage and the capacity variation increase as charging progresses; and

the discharging curved line progresses in a direction in which the voltage and the capacity variation decrease as discharging progresses.

15. The battery characteristic detection method of any of clauses 11 to 14, wherein:

the charging/discharging curved line of each of the plurality of charging/discharging cycles includes a charging curved line corresponding to the charging section and a discharging curved line corresponding to the discharging section; and

the generating of the charging/discharging curved line includes:

generating the charging/discharging curved line so that the capacity variation at the end time point of the discharging curved line is the same as the capacity variation at the start time point of the charging curved line for each charging/discharging cycle, or

generating the charging/discharging curved line so that the capacity variation at the end time point of the charging curved line is the same as the capacity variation at the start time point of the discharging curved line for each charging/discharging cycle.

16. The battery characteristic detection method of any of clauses 11 to 15, wherein:
the generating of the charging/discharging curved line includes generating the charging/discharging curved line so that the capacity variation at the start time point of each charging/discharging cycle is the same as the capacity variation at the end time point of the previous charging/discharging cycle thereof.

17. The battery characteristic detection method of any of clauses 11 to 16, wherein:

the charging/discharging curved line of the first charging/discharging cycle includes a first charging curved line corresponding to the charging section and a first discharging curved line corresponding to the discharging section; and
the charging/discharging curved line of a second charging/discharging cycle among the plurality of charging/-discharging cycles includes a second charging curved line corresponding to the charging section and a second discharging curved line corresponding to the discharging section; and
the battery characteristic detection method further includes:

generating an open circuit voltage curved line using an average voltage between the first charging curved line and the first discharging curved line; and
determining an overvoltage of a section in which the second charging/discharging cycle progresses, from a voltage difference between the second charging curved line and the open circuit voltage curved line and a voltage difference between the second discharging curved line and the open circuit voltage curved line.

18. The battery characteristic detection method of clause 17, further comprising determining a dynamic resistance of a section in which the second charging/discharging cycle progresses using the overvoltage and the current measured in the second charging/discharging cycle.

19. The battery characteristic detection method of clause 17 or clause 18, wherein the first charging/discharging cycle and the second charging/discharging cycle have different charging/discharging rates.

## Claims

1. A battery characteristic detection device of a rechargeable battery, comprising:

a control device configured to:
detect voltages and capacity variations of the rechargeable battery during a plurality of continuous charging/-discharging cycles; and
generate a charging/discharging curved line representing a relationship between the voltage and the capacity variation for each of the plurality of charging/discharging cycles,
wherein each of the plurality of charging/discharging cycles includes a charging section and a discharging section, and
wherein the control device is further configured to:

select one of the charging section and the discharging section of a first charging/discharging cycle among the plurality of charging/discharging cycles as a reference section; and
determine a capacity of the rechargeable battery at a start or end time point of the reference section as a reference capacity, and obtain the capacity variation based on the reference capacity.

2. The battery characteristic detection device of claim 1, wherein:

a charging/discharging rate in the first charging/discharging cycle is 0.05 C or less; and
the control device is further configured to:

determine a time point at which a state of charge (SOC) of the rechargeable battery is 0 % and a time point at which the SOC of the rechargeable battery is 100 % based on the start and end time points of the reference section; and
determine a capacity of the rechargeable battery at a time point at which the SOC of the rechargeable battery is 0 % or 100 % as the reference capacity.

3. The battery characteristic detection device of claim 1 or claim 2, wherein:
the control device is further configured to:

determine a capacity of the rechargeable battery at the start time point of the discharging section of the first charging/discharging cycle or the end time point of the charging section of the first charging/discharging cycle as the reference capacity; and
calculate a discharged capacity as the capacity variation based on the reference capacity; and wherein:

the charging/discharging curved line of each of the plurality of charging/discharging cycles includes a charging curved line corresponding to the charging section and a discharging curved line corresponding to the discharging section;
the discharging curved line progresses in a direction in which the voltage decreases and the capacity variation increases as discharging progresses; and
the charging curved line progresses in a direction in which the voltage increases and the capacity variation decreases as charging progresses.

4. The battery characteristic detection device of any preceding claim, wherein:
the control device is further configured to:

determine a capacity at the start time point of the charging section of the first charging/discharging cycle or the end time point of the discharging section of the first charging/discharging cycle as the reference capacity; and
calculate a charged capacity as the capacity variation based on the reference capacity; and wherein:

the charging/discharging curved line of each of the plurality of charging/discharging cycles includes a charging curved line corresponding to the charging section and a discharging curved line corresponding to the discharging section;
the charging curved line progresses in a direction in which the voltage and the capacity variation increase as charging progresses; and
the discharging curved line progresses in a direction in which the voltage and the capacity variation decrease as discharging progresses.

5. The battery characteristic detection device of any preceding claim, wherein:

the charging/discharging curved line of each of the plurality of charging/discharging cycles includes a charging curved line corresponding to the charging section and a discharging curved line corresponding to the discharging section; and
the control device is further configured to generate the charging/discharging curved line so that, for each charging/discharging cycle, the capacity variation at the end time point of the discharging curved line is the same as the capacity variation at the start time point of the charging curved line, or the capacity variation at the end time point of the charging curved line is the same as the capacity variation at the start time point of the discharging curved line.

6. The battery characteristic detection device of any preceding claim, wherein the control device is further configured to generate the charging/discharging curved line so that the capacity variation at the start time point of each charging/discharging cycle is the same as the capacity variation at the end time point of the previous charging/discharging cycle thereof.

7. The battery characteristic detection device of any preceding claim, wherein:

the charging/discharging curved line of the first charging/discharging cycle includes a first charging curved line corresponding to the charging section and a first discharging curved line corresponding to the discharging section; and
the control device is further configured to generate an open circuit voltage curved line using an average voltage value between the first charging curved line and the first discharging curved line.

8. The battery characteristic detection device of claim 7, wherein:

the charging/discharging curved line of a second charging/discharging cycle among the plurality of charging/-

discharging cycles includes a second charging curved line corresponding to the charging section of the second charging/discharging cycle and a second discharging curved line corresponding to the discharging section of the second charging/discharging cycle; and

the control device is configured to determine an overvoltage in the second charging/discharging cycle, based on a voltage difference between the second charging curved line and the open circuit voltage curved line and a voltage difference between the second discharging curved line and the open circuit voltage curved line.

9. The battery characteristic detection device of claim 8, wherein the control device is further configured to determine a dynamic resistance in the second charging/discharging cycle using the overvoltage and a charging/discharging current in the second charging/discharging cycle.

10. The battery characteristic detection device of claim 8 or claim 9, wherein the first charging/discharging cycle and the second charging/discharging cycle have different charging/discharging rates.

11. A battery characteristic detection method of a battery characteristic detection device, comprising:

measuring a voltage and a current of a rechargeable battery during a plurality of continuous charging/discharging cycles;

obtaining a capacity variation of the rechargeable battery at each voltage measurement time point based on the measured current; and

generating a charging/discharging curved line representing a relationship between the voltage and the capacity variation for each of the plurality of charging/discharging cycles,

wherein each of the plurality of charging/discharging cycles includes a charging section and a discharging section, and

wherein the obtaining of the capacity variation includes:

selecting one of the charging section and the discharging section of a first charging/discharging cycle among the plurality of charging/discharging cycles as a reference section;

determining a capacity of the rechargeable battery at a start or end time point of the reference section as a reference capacity; and calculating the capacity variation based on the reference capacity.

12. The battery characteristic detection method of claim 11, wherein:

the calculating includes calculating a discharged capacity as the capacity variation based on the reference capacity;

the charging/discharging curved line of each of the plurality of charging/discharging cycles includes a charging curved line corresponding to the charging section and a discharging curved line corresponding to the discharging section;

the discharging curved line progresses in a direction in which the voltage decreases and the capacity variation increases as discharging progresses; and

the charging curved line progresses in a direction in which the voltage increases and the capacity variation decreases as charging progresses.

13. The battery characteristic detection method of claim 11 or claim 12, wherein:

the calculating includes calculating a charged capacity as the capacity variation based on the reference capacity;

the charging/discharging curved line of each of the plurality of charging/discharging cycles includes a charging curved line corresponding to the charging section and a discharging curved line corresponding to the discharging section;

the charging curved line progresses in a direction in which the voltage and the capacity variation increase as charging progresses; and

the discharging curved line progresses in a direction in which the voltage and the capacity variation decrease as discharging progresses.

14. The battery characteristic detection method of any of claims 11 to 13, wherein:

the charging/discharging curved line of each of the plurality of charging/discharging cycles includes a charging curved line corresponding to the charging section and a discharging curved line corresponding to the discharging section; and
the generating of the charging/discharging curved line includes:

generating the charging/discharging curved line so that the capacity variation at the end time point of the discharging curved line is the same as the capacity variation at the start time point of the charging curved line for each charging/discharging cycle, or
generating the charging/discharging curved line so that the capacity variation at the end time point of the charging curved line is the same as the capacity variation at the start time point of the discharging curved line for each charging/discharging cycle.

**15.** The battery characteristic detection method of any of claims 11 to 14, wherein:

the charging/discharging curved line of the first charging/discharging cycle includes a first charging curved line corresponding to the charging section and a first discharging curved line corresponding to the discharging section; and
the charging/discharging curved line of a second charging/discharging cycle among the plurality of charging/-discharging cycles includes a second charging curved line corresponding to the charging section and a second discharging curved line corresponding to the discharging section; and
the battery characteristic detection method further includes:

generating an open circuit voltage curved line using an average voltage between the first charging curved line and the first discharging curved line; and
determining an overvoltage of a section in which the second charging/discharging cycle progresses, from a voltage difference between the second charging curved line and the open circuit voltage curved line and a voltage difference between the second discharging curved line and the open circuit voltage curved line.

# FIG. 1

# FIG. 2A

# FIG. 2B

# FIG. 3A

# FIG. 3B

# FIG. 4

# FIG. 5

# FIG. 6

# FIG. 7

# FIG. 8

# FIG. 9

Perform a plurality of continuous charging/discharging cycles — S11

Detect voltage and capacity variation of rechargeable battery — S12

Generate charging/discharging curved line of each charging/discharging cycle — S13

Determine pseudo OCV curved line — S14

Detect overvoltage — S15

Detect dynamic resistance — S16

Display battery characteristic — S17

| | Europäisches Patentamt European Patent Office Office européen des brevets | **EUROPEAN SEARCH REPORT** | **Application Number** EP 25 16 6612 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/276314 A1 (KIM JI-YEON [KR] ET AL) 1 September 2022 (2022-09-01) * abstract * * paragraph [0053] - paragraph [0212]; figures 1-9 * | 1-15 | INV. G01R31/367 G01R31/3842 G01R31/388 G01R31/392 H01M10/48 H02J7/00 |
| A | US 2014/077769 A1 (MALEKI HOSSEIN [US] ET AL) 20 March 2014 (2014-03-20) * abstract * * paragraph [0053] - paragraph [0071]; figures 4-6 * | 1-15 | |
| A | JP 2001 110459 A (NEC MOBILE ENERGY KK) 20 April 2001 (2001-04-20) * the whole document * | 1-15 | |
| A | US 2006/022676 A1 (UESAKA SHINICHI [JP] ET AL) 2 February 2006 (2006-02-02) * abstract * * paragraph [0052] - paragraph [0149]; figures 1-16 * | 1-15 | |
| A | US 2017/102436 A1 (TAO YOHEI [JP] ET AL) 13 April 2017 (2017-04-13) * abstract * * paragraph [0060] - paragraph [0182]; figures 1-21 * | 1-15 | TECHNICAL FIELDS SEARCHED (IPC) G01R H01M H02J |
| A | CN 116 908 729 A (DEEPAL AUTOMOBILE TECHNOLOGY CO LTD) 20 October 2023 (2023-10-20) * the whole document * | 1-15 | |
| A | US 2020/011933 A1 (OTAGIRI TOSHIO [JP] ET AL) 9 January 2020 (2020-01-09) * abstract * * paragraph [0018] - paragraph [0101]; figures 1-7 * | 1-15 | |

The present search report has been drawn up for all claims

| Place of search | Date of completion of the search | Examiner |
|---|---|---|
| Munich | 5 September 2025 | Bergado Colina, J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 6612

This annex lists the patent family members relating to the patent documents cited in the above-mentioned European search report.
The members are as contained in the European Patent Office EDP file on
The European Patent Office is in no way liable for these particulars which are merely given for the purpose of information.

05-09-2025

| Patent document cited in search report | | | Publication date | Patent family member(s) | | | Publication date |
|---|---|---|---|---|---|---|---|
| US 2022276314 | A1 | | 01-09-2022 | CN | 114270202 | A | 01-04-2022 |
| | | | | EP | 4012427 | A1 | 15-06-2022 |
| | | | | ES | 2994208 | T3 | 20-01-2025 |
| | | | | HU | E068013 | T2 | 28-12-2024 |
| | | | | JP | 7279294 | B2 | 23-05-2023 |
| | | | | JP | 2022539744 | A | 13-09-2022 |
| | | | | KR | 20210031226 | A | 19-03-2021 |
| | | | | PL | 4012427 | T3 | 23-09-2024 |
| | | | | US | 2022276314 | A1 | 01-09-2022 |
| | | | | WO | 2021049882 | A1 | 18-03-2021 |
| US 2014077769 | A1 | | 20-03-2014 | CN | 105052001 | A | 11-11-2015 |
| | | | | EP | 2898584 | A2 | 29-07-2015 |
| | | | | KR | 20150072409 | A | 29-06-2015 |
| | | | | US | 2014077769 | A1 | 20-03-2014 |
| | | | | WO | 2014046805 | A2 | 27-03-2014 |
| JP 2001110459 | A | | 20-04-2001 | NONE | | | |
| US 2006022676 | A1 | | 02-02-2006 | AU | 2003277559 | A1 | 15-06-2004 |
| | | | | CN | 1732389 | A | 08-02-2006 |
| | | | | EP | 1562048 | A1 | 10-08-2005 |
| | | | | JP | 4032934 | B2 | 16-01-2008 |
| | | | | JP | 2004163360 | A | 10-06-2004 |
| | | | | KR | 20050074531 | A | 18-07-2005 |
| | | | | TW | I250297 | B | 01-03-2006 |
| | | | | US | 2006022676 | A1 | 02-02-2006 |
| | | | | WO | 2004046742 | A1 | 03-06-2004 |
| US 2017102436 | A1 | | 13-04-2017 | CN | 104813534 | A | 29-07-2015 |
| | | | | DE | 112013005733 | T5 | 10-09-2015 |
| | | | | JP | 6252487 | B2 | 27-12-2017 |
| | | | | JP | WO2014083813 | A1 | 05-01-2017 |
| | | | | US | 2015301123 | A1 | 22-10-2015 |
| | | | | US | 2017102436 | A1 | 13-04-2017 |
| | | | | WO | 2014083813 | A1 | 05-06-2014 |
| CN 116908729 | A | | 20-10-2023 | NONE | | | |
| US 2020011933 | A1 | | 09-01-2020 | DE | 112018001005 | T5 | 07-11-2019 |
| | | | | JP | 6555442 | B2 | 07-08-2019 |
| | | | | JP | WO2018155247 | A1 | 18-07-2019 |
| | | | | US | 2020011933 | A1 | 09-01-2020 |
| | | | | WO | 2018155247 | A1 | 30-08-2018 |

EPO FORM P0459

For more details about this annex : see Official Journal of the European Patent Office, No. 12/82